# EUROPEAN PATENT APPLICATION

(11) **EP 1 755 025 A2**
(43) Date of publication of application: **21.02.2007**
(21) Application number: 06254160.2
(22) Date of filing: 08.08.2006
(51) Int. Cl.: G06F 3/033

(54) **Drop and drag logic analyzer trigger**

(30) Priority: 15.08.2005 US 708441 P; 19.05.2006 US 437243
(71) Applicant: TEKTRONIX, INC., Beaverton, OR 97077-0001 (US)
(72) Inventor: Thums, Eric, Portland, Oregon 97219 (US); Adam, Susan C., Portland, Oregon 97213 (US); Briscoe, Mark A., Beaverton, Oregon 97007 (US); Loofburrow, Andrew, Portland, Oregon 97225 (US)
(74) Representative: Burke, Steven David

(57) **Abstract**

A method of setting up a trigger function within the context of a data display on a logic analyzer provides a trigger setup window adjacent to the data display with a plurality of trigger setup icons. One of the trigger setup icons is selected as the trigger function, and a pointer representing the trigger function is dragged to a position on the data display. Dropping the pointer at the position on the data display completes the trigger function setup. An informational box associated with the pointer indicates the trigger function and a current parameter for the trigger function according to the location of the pointer on the data display. At completion of the trigger function setup, the trigger setup window provides the trigger function setup and allows an operator to edit the trigger function setup. The trigger function is executed at the next run of the logic analyzer.

## Description

### BACKGROUND OF THE INVENTION

The current invention relates to acquisition of data by a logic analyzer, and more particularly to a drop and drag logic analyzer trigger for identifying the data to be acquired.

A logic analyzer is a measurement instrument that is used in the testing and analysis of digital circuits. Generally digital circuits include one or more buses for the transferral of data, commands and other information, with each bus having a plurality of lines or channels. The multiple channels are each sampled in parallel, producing a great number of samples of data for analysis. However a user only desires to see data that is significant, i.e., which represents a condition of interest or particular state of the digital circuit being tested. Therefore the user needs to establish criteria for the acquisition of the data of interest, i.e., identify some characteristic of the data to serve as a trigger event for filling an acquisition memory in the logic analyzer such that the acquisition memory contains samples of the data that surround the trigger event from all the designated channels in parallel. The acquired data may then be displayed as waveforms for each channel and the corresponding buses or as tables of values on the buses represented by the data.

As an initial analysis tool the user may elect to select a default trigger function, such as the "Trigger on Anything" function found in logic analyzers manufactured by Tektronix, Inc. of Beaverton, Oregon. The default trigger function causes the logic analyzer to capture the data stream as soon as a "Run" process is activated, i.e., captures an initial set of data samples for the channels being monitored which fills the acquisition memory. However finding problems or key behaviors in the data for further analysis may be difficult. The Tektronix logic analyzers currently provide two trigger program user interfaces for identifying a trigger function: "EasyTrigger" and "PowerTrigger". However to create a trigger program that sets up a trigger function, users have to go to a separate modal dialog screen in lieu of a data display of the acquired data. The EasyTrigger provides pre-canned setups for the trigger function from which the user selects, while the PowerTrigger is a state-based selection process in which the user inputs the required states for the trigger function. It is not easy to reference an existing feature in a data display while manipulating these trigger setup dialogs. Setting up the trigger functions requires the user to have a good understanding of the basic logic analyzer triggering capabilities as well as the data feature to be used as the trigger event, i.e., the trigger function is set up without the context of the data display.

Agilent Technologies, Inc. of Palo Alto, California has Advanced Trigger and Simple/Quick Trigger functions. The Advanced Trigger function is similar to the EasyTrigger and PowerTrigger functions mentioned above. However the Simple/Quick Trigger function operates within the context of a waveform data display. Every time a user draws a rectangular area on the waveform data display, the Quick Trigger is defined, as shown in Fig. 1 and described in detail in U.S. Patent No. 6,615,369. An informational box is provided which indicates the times encompassed by the rectangle as well as the most probable trigger condition based on the waveform data displayed within the rectangle - My Bus 1 [0] = Falling Edge. The user is presented with a drop down menu with the option to "Set Quick Trigger." There is no way for the user to modify the Quick Trigger - they can either choose it or ignore it.

When the Simple Trigger function is selected a trigger option is shown for each line or channel on the bus adjacent the corresponding waveform data display, shown as Bus1 in Fig. 17 of U.S. Patent No. 6,624,829. The user may then set up the appropriate conditions for each channel to establish the trigger criteria selected from a set of specified conditions.

What is desired is a more flexible, intuitive method of setting up trigger functions that is easy for even non-experienced operators to use.

### BRIEF SUMMARY OF THE INVENTION

Accordingly the present invention provides a "drag and drop" simple method for setting up a trigger function for a logic analyzer using a graphical user interface (GUI). The method of setting up the trigger function occurs within the context of a data display, and provides a trigger setup window adjacent to the data display with a plurality of trigger setup icons. One of the trigger setup icons is selected, and a pointer representing the trigger function is dragged to a position on the data display. Dropping the pointer at the position on the data display completes the trigger function setup. An informational box associated with the pointer indicates the trigger function and a current parameter for the trigger function according to the location of the pointer on the data display. At completion of the trigger function setup, the trigger setup dialog provides the trigger function setup which an operator may then edit. The trigger function is executed at the next data acquisition.

The objects, advantages and other novel features of the present invention are apparent from the following detailed description when read in conjunction with the appended claims and attached drawing.

### BRIEF DESCRIPTION OF THE SEVERAL VIEWS OF THE DRAWING

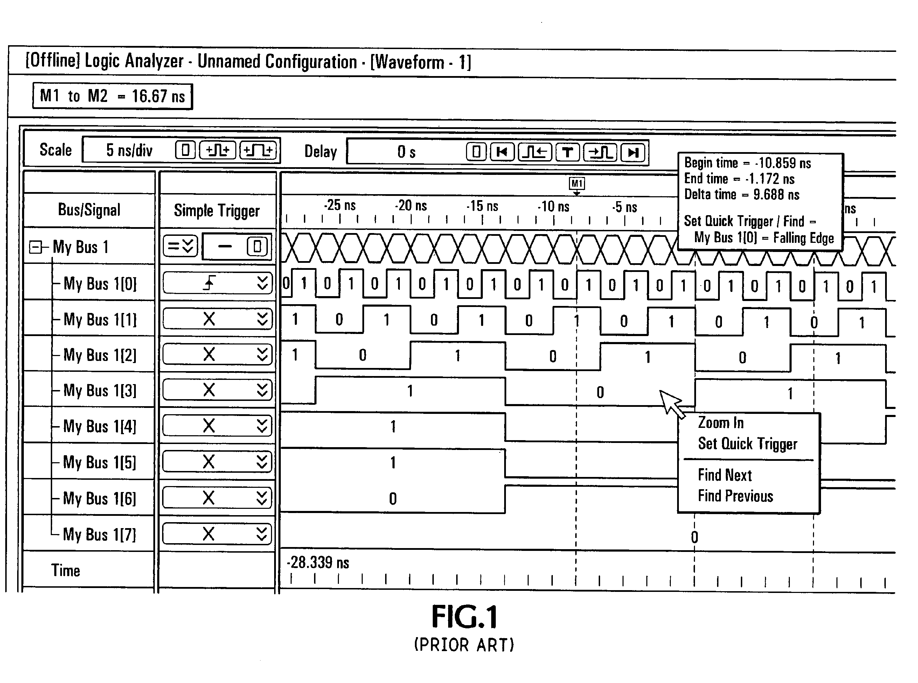

Fig. 1 is a plan view of a logic analyzer waveform data display for setting up a trigger function according to the prior art.

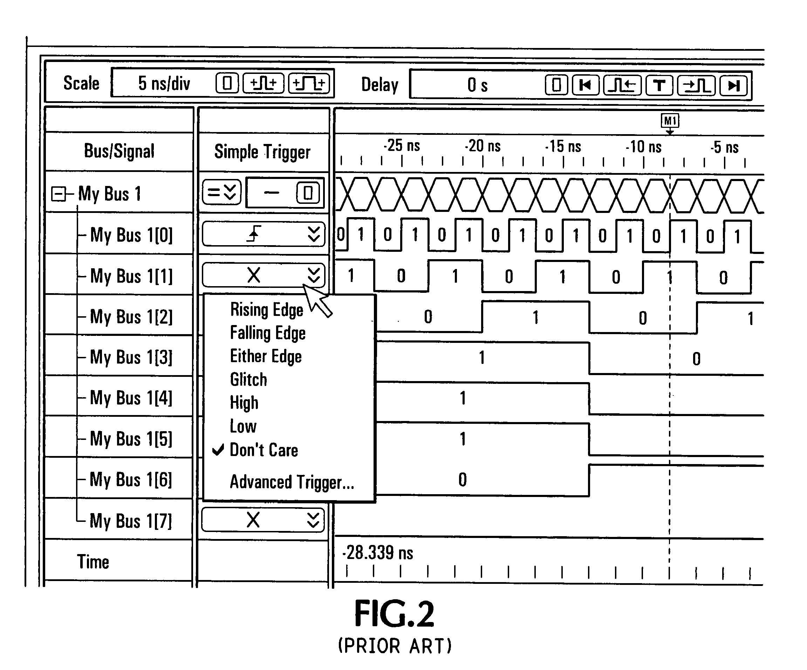

Fig. 2 is a plan view of a logic analyzer waveform data display for alternatively setting up a trigger function according to the prior art.

Fig. 3 is a plan view of a logic analyzer waveform data display having the ability to set up a trigger function according to the present invention.

Fig. 4 is a plan view of a logic analyzer waveform data display having an adjacent trigger setup window according to the present invention.

Fig. 5 is a plan view of a logic analyzer waveform data display having a trigger function being dragged and dropped on the waveform data display according to the present invention.

Fig. 6 is a plan view of a window indicating the result of the drag and drop operation suitable for editing according to the present invention.

Fig. 7 is a plan view of a logic analyzer list data display having an adjacent trigger setup window according to the present invention.

### DETAILED DESCRIPTION OF THE INVENTION

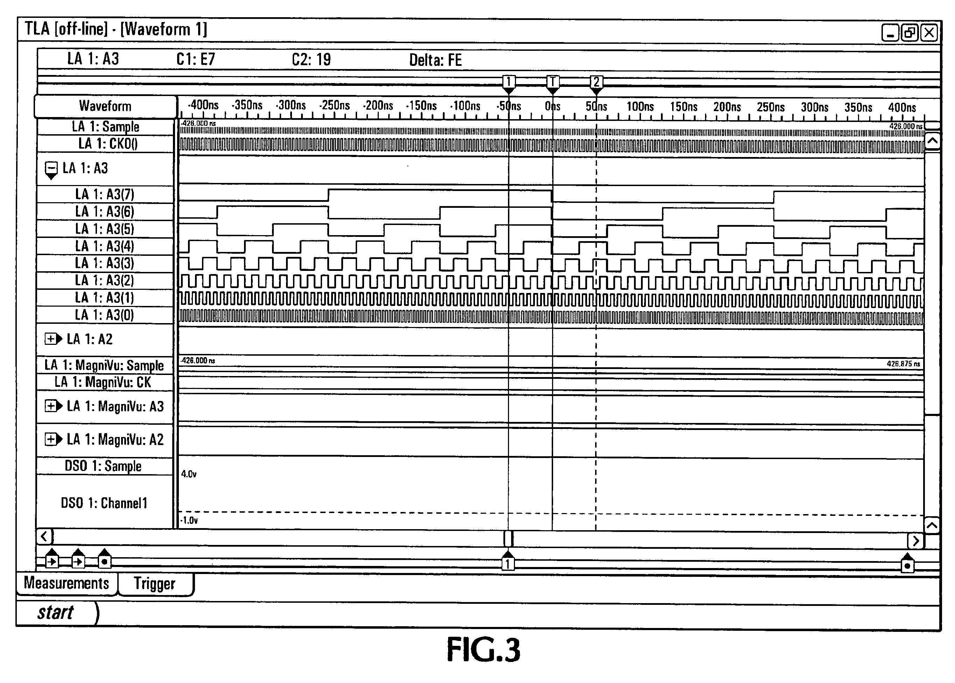

Fig. 3 shows a waveform data display for two data buses, LA 1: A2 and LA 1: A3, with the channels for one of the data buses shown in detail - LA 1: A3[0] - LA 1: A3[7]. A trigger point T is indicated on the display with time measured plus and minus from that point. Also cursors are shown that indicate the portion of the total data acquisition shown at the bottom of the display that is included in the waveforms shown at the top of the display. The samples for this waveform data display may initially have been acquired using a Trigger on Anything function as discussed above. There are two tabs indicated at the bottom of the display - one for Measurements and one for Trigger.

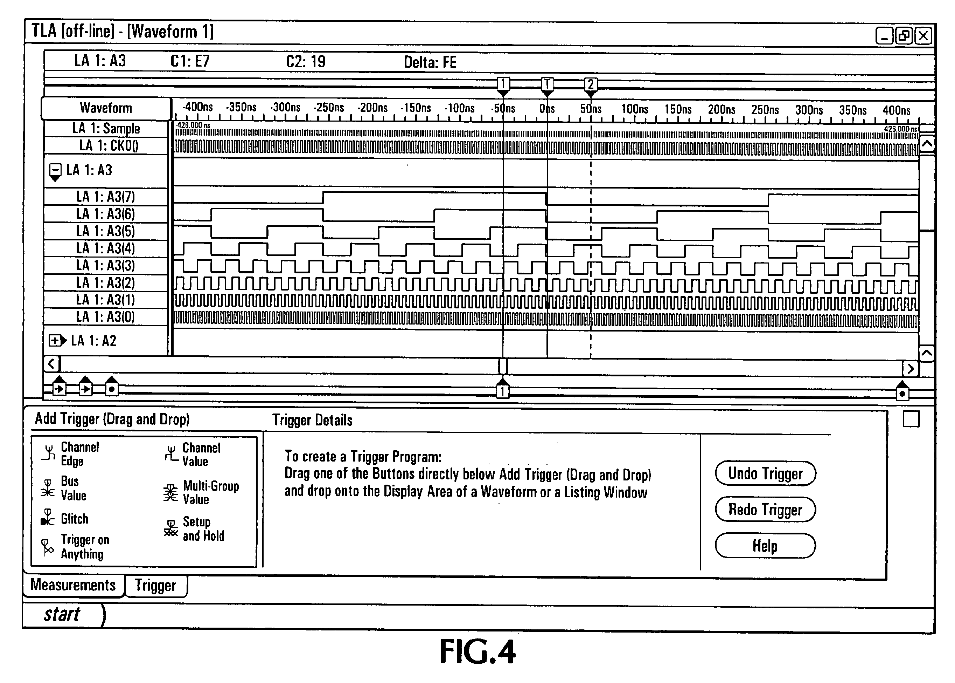

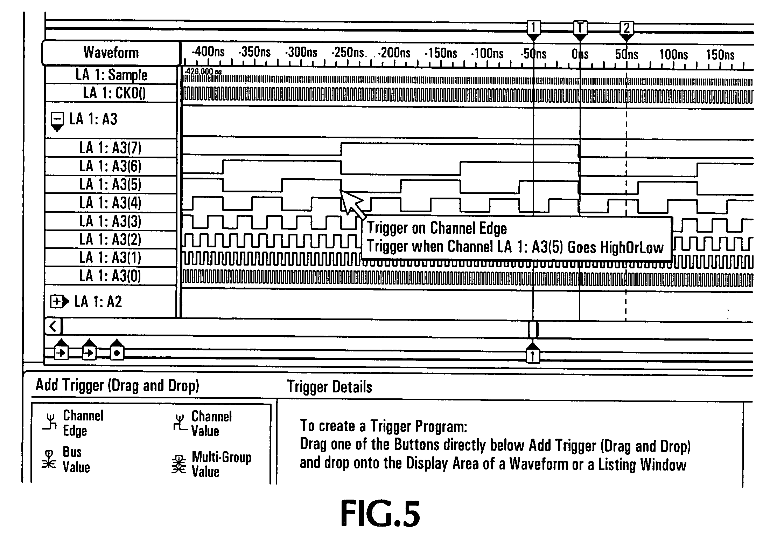

When the Trigger tab is selected the a portion of the display is replaced with a Drag and Drop trigger setup window, shown as the bottom portion in Fig. 4. The operator is given a choice of a plurality of trigger functions. In the illustrated view the operator may choose from the list of Channel Edge, Channel Value, Bus Value, Multi-Group Value, Glitch, Setup and Hold and Trigger on Anything. An operator may choose one of these trigger functions by "clicking" on the appropriate icon and "dragging" it to the waveform data display area in the form of a pointer, such as an arrow or other suitable indicator. On the waveform data display an informational box appears associated with the pointer, as shown in Fig. 5. In this particular illustration the Channel Edge trigger function is selected, and the informational box indicates the selected function together with a trigger parameter associated with the current location of the pointer. The pointer is positioned on data for channel LA 1:A3[5], near to but not exactly at an edge. The informational box indicates the parameter as Trigger when Channel LA 1 :A3[5] Goes HighOrLow, i.e., trigger on any edge for that channel. If the point is approximately at a particular edge (within a specified number of pixels), then the informational box indicates that the trigger occurs when that type of edge occurs - rising or falling. "Dropping" the pointer at that location completes the setup for the trigger function. The informational box also indicates when the pointer is at a location where it can't be dropped, i.e., a location where the selected trigger function is inoperable.

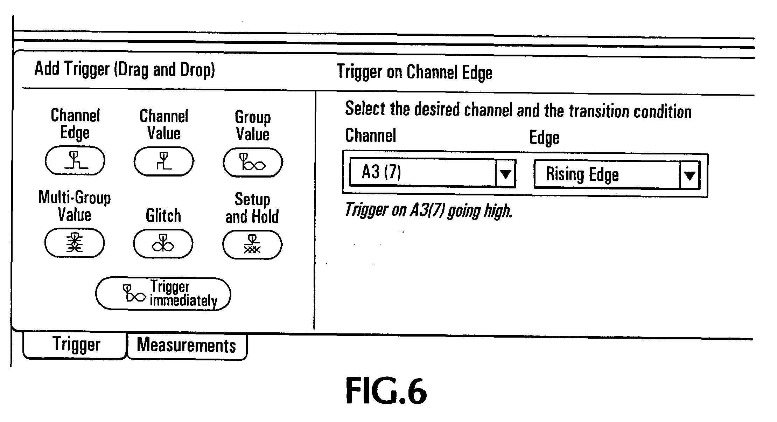

Once the trigger function has been located on the waveform data display, the trigger window at the bottom indicates the current selected trigger setup. The operator may now edit the information displayed so that now, for example, the trigger function occurs at the rising edge of channel A3[7], as shown in Fig. 6.

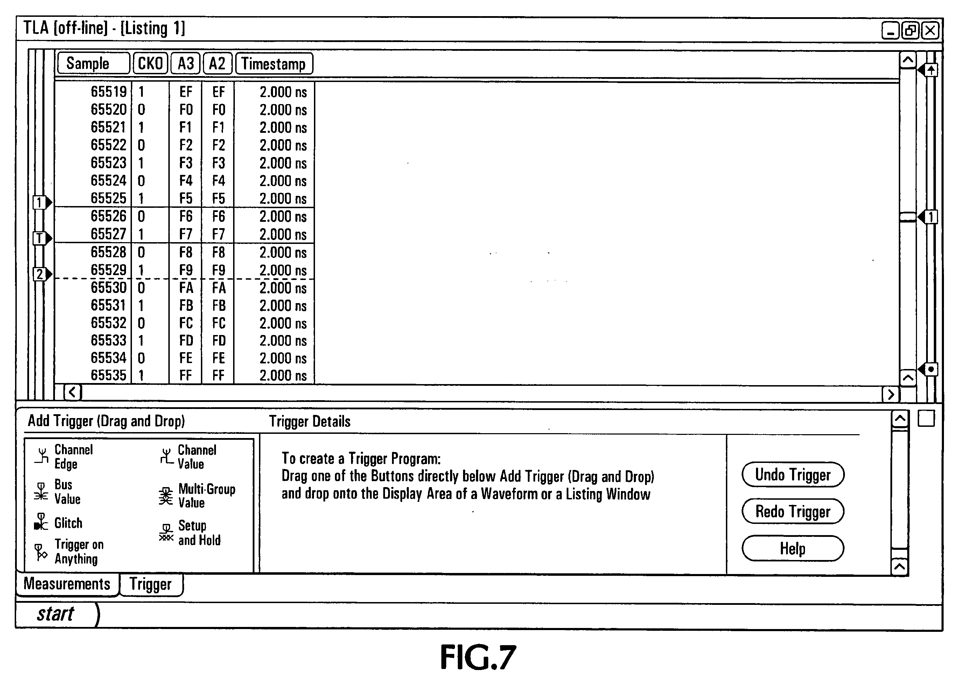

Also as shown in Fig. 7 the same trigger tab may be used in conjunction with the list data display. The two groups LA 1: A2 and LA 1: A3 are shown with a hexadecimal value for each time interval. The selected trigger function may be selected, dragged and dropped on a particular line of the list data display. The resulting window showing the selected trigger function and values appears in a similar window to that of Fig. 6, with the groups or buses identified, the values displayed and a selection of either one or both group values indicated. Again these values may be edited by the operator.

A similar drag and drop apparatus and method for performing analog-type measurements, as opposed to trigger function setup, is disclosed in copending U.S. Patent Application Serial No. 11/435,571, filed 16 May 2006, entitled "Analog-Type Measurements for a Logic Analyzer."

Thus the present invention provides a simplified trigger function setup method using a drag and drop technique for selecting one of a plurality of trigger functions, dragging it to a data display, and dropping it at a particular location within the data display to complete the setup while providing the ability for an operator to edit the setup.

## Claims

1. A method of setting up a trigger function within the context of a data display comprising the steps of:
providing a trigger window adjacent the data display, the trigger window containing a plurality of trigger setup icons representing a corresponding plurality of trigger functions;
selecting one of the trigger setup icons as the trigger function;
dragging the selected trigger function to a position on the data display, a pointer indicating a current position on the data display; and
dropping the selected trigger function at the position to complete setup of the trigger function.

2. The method as recited in claim 1 further comprising the step of editing the setup of the trigger function after the dropping step.

3. The method as recited in claim 1 further comprising the steps of:
converting the selected trigger setup icon to a pointer when dragged onto the data display; and
associating an informational box with the pointer to indicate the trigger function and a current parameter for the trigger function according to a location of the pointer on the data display.

4. The method as recited in claim 1 further comprising the step of reading the current location of the pointer as the pointer is dragged to populate a trigger definition window based on the current location and associated data values.
